# EUROPEAN PATENT APPLICATION

(11) **EP 4 654 277 A1**
(43) Date of publication of application: **26.11.2025**
(21) Application number: 23929813.6
(22) Date of filing: 07.09.2023
(51) Int. Cl.: H01M 4/131, H01M 4/36

(54) **POSITIVE ELECTRODE SHEET AND PREPARATION METHOD THEREFOR, ELECTRODE ASSEMBLY, BATTERY CELL, BATTERY, AND ELECTRIC APPARATUS**

(30) Priority: 28.03.2023 CN 202310312883
(71) Applicant: Contemporary Amperex Technology (Hong Kong) Limited, Hong Kong (HK)
(72) Inventor: REN, Miaomiao, Ningde, Fujian 352100 (CN); WEI, Yimin, Ningde, Fujian 352100 (CN)
(74) Representative: Ziebig Hengelhaupt Intellectual Property Attorneys Patentanwaltskanzlei PartGmbB
(86) International application number: PCT/CN2023/117560
(87) International publication number: WO 2024/198239

(57) **Abstract**

This application relates to the field of battery technologies, specifically to, a positive electrode plate and a preparation method thereof, an electrode assembly, a battery cell, a battery, and an electric apparatus. The positive electrode plate includes a current collector and a coating disposed on at least one side of the current collector. The coating is provided with a protective film on the surface, and a material of the protective film includes a fluoride. Considering that contact between a positive electrode material in the coating and air leads to performance degradation, and contact between the positive electrode material and an electrolyte causes interfacial side reactions, the protective film is disposed on the surface of the coating to improve the performance of the positive electrode material. This reduces the opportunity for contact between the positive electrode material and air and mitigates the probability of interfacial reactions between the positive electrode material and the electrolyte, enhancing the stability of the positive electrode material, thereby improving the performance of the battery.

## Description

### CROSS-REFERENCE TO RELATED APPLICATIONS

This application claims priority to Chinese Patent Application No. 202310312883.9 filed on March 28, 2023, which is incorporated herein by reference in its entirety.

### TECHNICAL FIELD

This application relates to the field of battery technologies, specifically to, a positive electrode plate and a preparation method thereof, an electrode assembly, a battery cell, a battery, and an electric apparatus.

### BACKGROUND

Lithium-ion batteries, due to their high operating potential, long lifespan, and environmentally friendly characteristics, have become the most popular energy storage systems and are widely used in fields such as battery electric vehicles, hybrid electric vehicles, and smart grids.

During the cycling process of lithium-ion batteries, a problem exists where the performance of the battery deteriorates.

### SUMMARY

The primary purpose of this application is to provide a positive electrode plate aimed at improving the performance of a battery.

To achieve the aforementioned purpose, this application proposes a positive electrode plate. The positive electrode plate includes a current collector and a coating disposed on at least one side of the current collector. The coating is provided with a protective film on the surface, and a material of the protective film includes a fluoride.

The positive electrode plate of this application includes a current collector and a coating disposed on at least one side of the current collector. The coating is provided with a protective film on the surface, and a material of the protective film includes a fluoride. Considering that contact between a positive electrode material in the coating and air leads to performance degradation, and contact between the positive electrode material and an electrolyte causes interfacial side reactions, the protective film is disposed on the surface of the coating to improve the performance of the positive electrode material. This reduces the opportunity for contact between the positive electrode material and air and mitigates the probability of interfacial reactions between the positive electrode material and the electrolyte, thereby enhancing the stability of the positive electrode material and improving the performance of the battery.

Optionally, a thickness range of the protective film is 1 nm to 50 nm, preferably 5 nm to 20 nm.

To allow the protective film to effectively reduce the opportunity for contact between the electrolyte and the coating while ensuring a favorable migration rate for lithium ions, the thickness range of the protective film is 1 nm to 50 nm, preferably 5 nm to 20 nm.

Optionally, the fluoride includes at least one of lithium fluoride and aluminum fluoride.

The fluoride includes at least one of lithium fluoride and aluminum fluoride. That is, the protective film may include both lithium fluoride and aluminum fluoride simultaneously, or may independently consist of lithium fluoride or aluminum fluoride. In some cases, other types of materials may be added to the protective film as needed. This application imposes no limitation, allowing design based on usage requirements.

Optionally, the protective film includes a lithium fluoride protective film and an aluminum fluoride protective film, where the lithium fluoride protective film and the aluminum fluoride protective film are stacked on the surface of the coating;
and/or, the protective film includes a lithium fluoride protective film and an aluminum fluoride protective film, where at least a portion of the surface of the coating is provided with the lithium fluoride protective film, and at least another portion of the surface of the coating is provided with the aluminum fluoride protective film.

The lithium fluoride protective film and the aluminum fluoride protective film are stacked on the surface of the coating. The lithium fluoride protective film 30a and the aluminum fluoride protective film 30b are alternately disposed on the surface of the coating 20. For example, the lithium fluoride protective film 30a is disposed on the surface of the coating 20, and the aluminum fluoride protective film 30b is disposed on a side of the lithium fluoride protective film 30a facing away from the coating 20. Alternatively, the aluminum fluoride protective film 30b may be disposed on the surface of the coating 20, and the lithium fluoride protective film 30a may be disposed on a side of the aluminum fluoride protective film 30b facing away from the coating 20. The number of layers of the lithium fluoride protective film 30a and the aluminum fluoride protective film 30b is not specifically limited. For instance, the lithium fluoride protective film 30a may consist of two layers, and the aluminum fluoride protective film 30b may consist of one layer, with the aluminum fluoride protective film 30b disposed between the two layers of the lithium fluoride protective film 30a. The arrangement can be set according to needs.

At least a portion of the surface of the coating is provided with the lithium fluoride protective film, and at least another portion of the surface of the coating is provided with the aluminum fluoride protective film. For the coating 20, at least a portion of the surface is provided with the lithium fluoride protective film 30a, and at least another portion of the surface of the coating 20 is provided with the aluminum fluoride protective film 30b. It can be understood that the lithium fluoride protective film 30a and the aluminum fluoride protective film 30b may be arranged side by side on one surface of the coating 20. No specific limitation is imposed, and consideration can be made based on needs.

Optionally, the coating includes a positive electrode material, a coating layer is formed on the surface of the positive electrode material, and the coating layer includes at least one of a sulfur-containing compound, a boron-containing compound, and a fluoride.

The positive electrode material, such as a ternary positive electrode material, particularly one with a higher nickel content, has a higher amount of residual lithium compounds on the surface during synthesis. Such surface residual lithium readily absorbs carbon dioxide and water from the air, forming layers of Li₂CO₃ and LiOH on the particle surface, which subsequently causes the following effects: the Li in the material is consumed and lacks electrochemical activity, leading to capacity fade; LiOH reacts with polyvinylidene fluoride (PVDF), causing gelation of the slurry; the LiOH remaining on the electrode plate may further react with the electrolyte LiPF₆, consuming Li ions in the electrolyte and producing HF, which further corrodes the positive electrode material body, causing surface degradation; a dense Li₂CO₃ layer on the surface of the positive electrode particles also hinders Li diffusion subsequently, affecting the electrical performance of the battery.

To address the above issues, residual lithium compounds are reduced or eliminated through chemical reactions, forming a coating layer with ionic conductivity on the surface of the positive electrode material to reduce battery polarization. The coating layer includes at least one of a sulfur-containing compound, a boron-containing compound, and a fluoride.

Optionally, the coating layer is lithium fluoride.

The coating layer being lithium fluoride is obtained through a reaction with ammonium fluoride. Residual lithium can be thoroughly removed by controlling the input amount of ammonium fluoride in the reaction. Additionally, controlling the operational steps can effectively remove reaction byproducts, thus avoiding the introduction of new impurities.

Moreover, the step of adding ammonium fluoride can be incorporated during the preparation process of the coating slurry, requiring no additional steps and enhancing the preparation efficiency of the positive electrode plate.

Optionally, a mass percentage of the lithium fluoride relative to a total mass of the positive electrode material is 0.01% to 5%, preferably 0.5% to 1.2%.

In the process of reacting residual lithium with ammonium fluoride to obtain a lithium fluoride coating layer, the amount of ammonium fluoride to be added can be calculated based on the amount of residual lithium in the positive electrode material to completely react the residual lithium. In the resulting positive electrode material, a mass percentage of the lithium fluoride relative to a total mass of the positive electrode material is 0.01% to 5%, preferably 0.5% to 1.2%.

Optionally, a general formula of the positive electrode material in the coating is LiₓNi_{y}M_{1-y}O₂, where 0.9 ≤ x ≤ 1.15, 0.6 ≤ y ≤ 1, and M is selected from one or more of Co, Mn, and Al;
and/or, a general formula of the positive electrode material in the coating is xLi₂MnO₃·(1-x)LiMO₂, where 0.1 ≤ x ≤ 0.9, and M is selected from one or more of Co, Mn, and Al.

The positive electrode material in the coating includes LiₓNi_{y}M_{1-y}O₂ with a layered structure, where 0.9 ≤ x ≤ 1.15, 0.6 ≤ y ≤ 1, and M is selected from one or more of Co, Mn, and Al; and/or includes a lithium-rich manganese-based positive electrode material xLi₂MnO₃·(1-x)LiMO₂, where 0.1 ≤ x ≤ 0.9, and M is selected from one or more of Co, Mn, and Al.

This application also provides a preparation method of a positive electrode plate, including:
preparing a positive electrode plate;
preparing a fluoride precursor; and
forming a protective film on the surface of a coating of the positive electrode plate through a thin-film deposition technique.

To form the protective film on the surface of the coating of the positive electrode plate, the steps include: preparing a positive electrode plate, preparing a fluoride precursor, and forming a protective film on the surface of the coating of the positive electrode plate through a thin-film deposition technique.

It can be understood that thin-film deposition techniques include chemical vapor deposition and physical vapor deposition. This application does not limit which deposition technique is used to form the protective film on the surface of the coating, allowing selection based on experimental conditions and actual needs.

Optionally, the thin-film deposition technique includes an atomic layer deposition process.

Thin-film deposition techniques include chemical vapor deposition and physical vapor deposition. No specific limitation is imposed on which process is selected. To achieve a better effect with the prepared protective film, an atomic layer deposition process is preferred. The atomic layer deposition process offers better chemical stoichiometry, strong stress control capability, a smooth film surface, a wide process window, and a broader range of precursor choices.

Optionally, the fluoride includes lithium fluoride and/or aluminum fluoride.

Fluorides can effectively reduce the oxidative activity on the surface of the positive electrode material, suppress oxidative decomposition of the electrolyte at the positive electrode, and promote lithium-ion transport in the solid phase. By preparing a fluoride precursor and utilizing a thin-film deposition technique, a fluoride protective film is formed on the surface of the coating of the positive electrode plate. The fluoride precursor includes a precursor of lithium fluoride and/or a precursor of aluminum fluoride.

Optionally, in the step of forming a coating layer on the surface of the coating of the positive electrode plate through an atomic layer deposition process, the process includes:
placing the positive electrode plate into a reaction chamber for atomic layer deposition, evacuating the chamber, and setting a deposition temperature to 200°C-250°C; and
introducing an appropriate fluoride precursor into the reaction chamber, forming a protective film on the surface of the coating, releasing the vacuum to remove unreacted precursor, and repeating the above steps to obtain a protective film of preset thickness.

The material of the protective film includes a fluoride. The type of fluoride is not specifically limited, and a precursor can be selected based on the chosen fluoride type. In the step of forming a coating layer on the surface of the coating of the positive electrode plate through an atomic layer deposition process, the process includes: placing the positive electrode plate into a reaction chamber for atomic layer deposition, evacuating the chamber, and setting a deposition temperature to 200°C-250°C; introducing an appropriate fluoride precursor into the reaction chamber, forming a protective film on the surface of the coating, releasing the vacuum to remove unreacted precursor, and repeating the above steps to obtain a protective film of preset thickness.

Optionally, in the step of introducing an appropriate fluoride precursor into the reaction chamber, forming a protective film on the surface of the coating, releasing the vacuum to remove unreacted precursor, and repeating the above steps to obtain a protective film of preset thickness, the process includes:
introducing a precursor of aluminum fluoride into the reaction chamber, forming a protective film on the surface of the coating, and releasing the vacuum to remove unreacted precursor;
introducing a precursor of lithium fluoride into the reaction chamber, forming a protective film on the surface of the coating, and releasing the vacuum to remove unreacted precursor; and
repeating the above steps to obtain the protective film of preset thickness.

The fluoride includes at least one of lithium fluoride and aluminum fluoride. To obtain a protective film of lithium fluoride and aluminum fluoride, in the step of introducing an appropriate fluoride precursor into the reaction chamber, forming a protective film on the surface of the coating, releasing the vacuum to remove unreacted precursor, and repeating the above steps to obtain a protective film of preset thickness, the process includes: introducing a precursor of aluminum fluoride into the reaction chamber, forming a protective film on the surface of the coating, and releasing the vacuum to remove unreacted precursor; introducing a precursor of lithium fluoride into the reaction chamber, forming a protective film on the surface of the coating, and releasing the vacuum to remove unreacted precursor; and repeating the above steps to obtain the protective film of preset thickness.

Optionally, in the step of introducing a precursor of aluminum fluoride into the reaction chamber, forming a protective film on the surface of the coating, and releasing the vacuum to remove unreacted precursors, the process includes:
evacuating the reaction chamber and reducing the pressure to 10 Pa or below;
introducing AlCl₃ gas into the reaction chamber and maintaining for 10s-20s;
introducing purge gas into the reaction chamber, releasing the vacuum to remove unreacted AlCl₃ gas;
reducing the pressure in the reaction chamber to 10 Pa or below, introducing TiF₄ gas into the reaction chamber, and maintaining for 10s-20s;
introducing purge gas into the reaction chamber, releasing the vacuum to remove unreacted TiF₄ gas; and
repeating the above steps to obtain an aluminum fluoride protective film of preset thickness.

The precursor of aluminum fluoride includes AlCl₃ and TiF₄. In the step of preparing an aluminum fluoride protective film, the process includes: evacuating the reaction chamber and reducing the pressure to 10 Pa or below; introducing AlCl₃ gas into the reaction chamber and maintaining for 10s-20s; introducing purge gas into the reaction chamber, releasing the vacuum to remove unreacted AlCl₃ gas; reducing the pressure in the reaction chamber to 10 Pa or below, introducing TiF₄ gas into the reaction chamber, and maintaining for 10s-20s; introducing purge gas into the reaction chamber, releasing the vacuum to remove unreacted TiF₄ gas; and repeating the above steps to obtain an aluminum fluoride protective film of preset thickness.

It can be understood that AlCl₃ and TiF₄ are solid at room temperature. To obtain gaseous precursors, a temperature capable of vaporizing the precursors is set to gasify the solids, yielding gaseous precursors.

It can be understood that the step of introducing AlCl₃ gas into the reaction chamber and maintaining for 10s-20s is to introduce an appropriate amount of AlCl₃ gas into the reaction chamber. The duration of gas introduction can be selected based on actual needs, and this application imposes no specific limitation.

Optionally, in the step of introducing a precursor of lithium fluoride into the reaction chamber, forming a protective film on the surface of the coating, and releasing the vacuum to remove unreacted precursors, the process includes:
evacuating the reaction chamber and reducing the pressure to 10 Pa or below;
introducing alkyl lithium vapor into the reaction chamber and maintaining for 10s-20s;
introducing purge gas into the reaction chamber, releasing the vacuum to remove unreacted alkyl lithium vapor;
reducing the pressure in the reaction chamber to 10 Pa or below, introducing TiF₄ vapor into the reaction chamber, and maintaining for 10s-20s;
introducing purge gas into the reaction chamber, releasing the vacuum to remove unreacted TiF₄ vapor; and
repeating the above steps to obtain a lithium fluoride protective film of preset thickness.

The precursor of lithium fluoride includes alkyl lithium and TiF₄. In the step of preparing a lithium fluoride protective film, the process includes: evacuating the reaction chamber and reducing the pressure to 10 Pa or below; introducing alkyl lithium vapor into the reaction chamber and maintaining for 10s-20s; introducing purge gas into the reaction chamber, releasing the vacuum to remove unreacted alkyl lithium vapor; reducing the pressure in the reaction chamber to 10 Pa or below, introducing TiF₄ vapor into the reaction chamber, and maintaining for 10s-20s; introducing purge gas into the reaction chamber, releasing the vacuum to remove unreacted TiF₄ vapor; and repeating the above steps to obtain a lithium fluoride protective film of preset thickness.

Optionally, in the step of preparing a positive electrode plate, the process includes:
mixing and reacting the positive electrode material with a reactive substance to form a coating layer on the surface of the positive electrode material;
mixing the positive electrode material with the coating layer, a binder, and a conductive agent, adding a solvent, and stirring to obtain a positive electrode slurry; and
applying the positive electrode slurry onto a current collector and performing drying to obtain the positive electrode plate;
where the reactive substance includes at least one of a sulfur compound and a boron compound.

Residual lithium exists on the surface of the positive electrode material, affecting the performance of the battery. To remove residual lithium, a reactive substance reacts with the residual lithium. For example, a sulfur compound or a boron compound is mixed with the positive electrode material and reacted under certain conditions to form a coating layer on the surface of the positive electrode material; the positive electrode material with the coating layer, a binder, and a conductive agent are mixed, a solvent is added and stirred to obtain a positive electrode slurry; and the positive electrode slurry is applied onto a current collector and dried to obtain the positive electrode plate.

Optionally, in the step of preparing a positive electrode plate, the process includes:
mixing the positive electrode material, a binder, a conductive agent, and ammonium fluoride, adding a solvent, and stirring to obtain a positive electrode slurry; and
applying the positive electrode slurry onto a current collector and performing drying to obtain the positive electrode plate.

Ammonium fluoride is introduced during the slurry preparation process to react with residual lithium on the surface of the positive electrode material, forming a lithium fluoride coating layer. This can reduce the residual alkali content on the surface of the positive electrode material as needed, thereby reducing battery polarization. Compared to mixing and reacting a sulfur compound or a boron compound with the positive electrode material under certain conditions to form a coating layer on the surface of the positive electrode material, using ammonium fluoride requires no additional steps; and ammonium fluoride is directly added during the slurry preparation process, reducing process steps and improving the production efficiency of the positive electrode plate.

By converting residual lithium as a reactant into an effective lithium fluoride protective layer, the gelation of the slurry is effectively improved, achieving the removal of residual lithium and establishing a fast ionic conductor coating layer. This enhances the conductivity of the positive electrode plate, reduces polarization in lithium-ion batteries, and improves the power performance of lithium-ion batteries.

Optionally, an addition amount of the ammonium fluoride relative to a mass of the positive electrode material ranges from 0.009% to 4.5%, preferably 0.45% to 1.1%.

In the process of removing residual lithium, the amount of ammonium fluoride to be added can be calculated based on the amount of residual lithium. An addition amount of the ammonium fluoride relative to a mass of the positive electrode material ranges from 0.009% to 4.5%, preferably 0.45% to 1.1%.

Optionally, in the step of mixing the positive electrode material, a binder, a conductive agent, and ammonium fluoride, adding a solvent, and stirring to obtain a positive electrode slurry, the process includes:
mixing the positive electrode material, the binder, the conductive agent, and ammonium fluoride for 5 min-60 min, adding the solvent, stirring at a rotation speed of 300 r/min-2000 r/min for 30 min to 3 h, and performing degassing and evacuating to obtain a positive electrode slurry with a solid content of 60%-85%.

To thoroughly mix ammonium fluoride with the positive electrode material during the slurry preparation process for effective reaction, the operation involves: mixing the positive electrode material, the binder, the conductive agent, and ammonium fluoride for 5 min-60 min, adding the solvent, stirring at a rotation speed of 300 r/min-2000 r/min for 30 min to 3 h, and performing degassing and evacuating to obtain a positive electrode slurry with a solid content of 60%-85%.

The reaction of ammonium fluoride with residual lithium involves the following chemical equations: 2NH₄F + LiCO₃ → 2LiF↓ + (NH₄)₂CO₃, NH₄F + LiOH → LiF↓ + NH₃↑ + H₂O↑.

The byproducts of the reaction are volatile or decompose into volatile substances. To facilitate the removal of byproducts, degassing and evacuating are performed during the operation.

That is, an equivalent amount of ammonium fluoride is calculated and used based on the residual lithium as the source. Under slurry stirring conditions, ammonium fluoride is thoroughly contacted, mixed uniformly, and reacted with the positive electrode material. After stirring, during the degassing stage, some gaseous byproducts are removed by evacuation.

Optionally, in the step of applying the positive electrode slurry onto a current collector and performing drying to obtain the positive electrode plate, the process includes:
applying the positive electrode slurry onto the current collector and performing drying at a temperature of 100°C-170°C to obtain the positive electrode plate.

To effectively ensure the decomposition and removal of the reaction byproduct (NH₄)₂CO₃, the drying process adjusts the drying temperature to decompose and remove ammonium carbonate. The drying temperature is 100°C-170°C. Under these drying conditions, the byproduct (NH₄)₂CO₃ decomposes and is discharged with the airflow, facilitating rapid decomposition and removal of (NH₄)₂CO₃ and improving production efficiency.

Optionally, proportions of residual lithium mass in the positive electrode material relative to the mass of the positive electrode material satisfy Li₂CO₃ ≥ 0.02% and LiOH ≥ 0.2%.

To prepare a coating layer with an appropriate coating mass that yields significant beneficial effects, proportions of residual lithium mass in the positive electrode material relative to the mass of the positive electrode material satisfy Li₂CO₃ ≥ 0.02% and LiOH ≥ 0.2%.

This application also provides an electrode assembly. The electrode assembly includes the positive electrode plate as described or includes a positive electrode plate prepared by the preparation method of the positive electrode plate as described.

This application also provides a battery cell. The battery cell includes the electrode assembly as described.

This application also provides a battery. The battery includes the battery cell as described.

This application also provides an electric apparatus. The electric apparatus includes the battery cell as described or the battery as described.

The positive electrode plate of this application includes a current collector and a coating disposed on at least one side of the current collector. The surface of the coating is provided with a protective film, and a material of the protective film includes a fluoride. Considering that contact between a positive electrode material in the coating and air leads to performance degradation, and contact between the positive electrode material and an electrolyte causes interfacial side reactions, the protective film is disposed on the surface of the coating to improve the performance of the positive electrode material. This reduces the opportunity for contact between the positive electrode material and air and mitigates the probability of interfacial reactions between the positive electrode material and the electrolyte, enhancing the stability of the positive electrode material, thereby improving the performance of the battery.

### BRIEF DESCRIPTION OF DRAWINGS

To describe the technical solutions in the embodiments of this application or in the prior art more clearly, the following briefly describes the accompanying drawings required for describing the embodiments or the prior art. Apparently, the accompanying drawings in the following description show only some embodiments of this application, and persons of ordinary skill in the art may still derive other drawings from structures shown in these accompanying drawings without creative efforts.
FIG. 1 is a schematic structural diagram of a positive electrode plate according to an embodiment of this application;
FIG. 2 is a schematic structural diagram of a positive electrode plate according to an embodiment of this application;
FIG. 3 is a schematic structural diagram of a positive electrode plate according to an embodiment of this application;
FIG. 4 is a flowchart of a preparation method of a positive electrode plate according to an embodiment of this application;
FIG. 5 is a schematic diagram of a battery cell according to an embodiment of this application;
FIG. 6 is an exploded view of the battery cell according to the embodiment of this application shown in FIG. 5;
FIG. 7 is a schematic diagram of a battery module according to an embodiment of this application;
FIG. 8 is a schematic diagram of a battery pack according to an embodiment of this application;
FIG. 9 is an exploded view of the battery pack according to the embodiment of this application shown in FIG. 8;
FIG. 10 is a schematic diagram of an electric apparatus using a secondary battery as a power source according to an embodiment of this application.

### Description of reference signs:

| Sign | Element | Sign | Element |
|---|---|---|---|
| 100 | Positive electrode plate | 2 | Upper box body |
| 10 | Current collector | 3 | Lower box body |
| 20 | Active layer | 4 | Battery module |
| 30 | Protective film | 5 | Battery cell |
| 30a | Lithium fluoride protective film | 51 | Housing |
| 30b | Aluminum fluoride protective film | 52 | Electrode assembly |
| 1 | Battery pack | 53 | Cover plate |

The achievement of the objectives, functional features, and advantages of this application are further described in connection with the embodiments and with reference to the accompanying drawings.

### DESCRIPTION OF EMBODIMENTS

The following clearly and completely describes the technical solutions in the embodiments of this application with reference to the accompanying drawings in the embodiments of this application. Apparently, the described embodiments are only some rather than all of the embodiments of this application. All other embodiments obtained by persons of ordinary skill in the art based on the embodiments of this application without creative efforts shall fall within the protection scope of this application.

Hereinafter, embodiments specifically disclosing a cathode electrode plate, an electrode assembly, a battery cell, a battery, and an electric apparatus of this application are described in detail with appropriate reference to the accompanying drawings. However, there may be cases in which unnecessary detailed descriptions are omitted. For example, detailed descriptions of well-known matters and repeated descriptions of actually identical structures have been omitted. This is to avoid unnecessarily prolonging the following descriptions, for ease of understanding by persons skilled in the art. In addition, the accompanying drawings and the following descriptions are provided for those skilled in the art to fully understand this application and are not intended to limit the subject described in the claims.

"Ranges" disclosed in this application are defined in the form of lower and upper limits. A given range is defined by one lower limit and one upper limit selected, where the selected lower and upper limits define boundaries of that special range. Ranges defined in this way may or may not include end values, and any combination may be used, meaning that any lower limit may be combined with any upper limit to form a range. For example, if ranges of 60-120 and 80-110 are provided for a specific parameter, ranges of 60-110 and 80-120 can also be envisioned. In addition, if low limit values of a range are given as 1 and 2, and upper limit values of the range are given as 3, 4, and 5, the following ranges can all be envisioned: 1-3, 1-4, 1-5, 2-3, 2-4, and 2-5. In this application, unless otherwise stated, a value range of "a-b" is a short representation of any combination of real numbers between a and b, where both a and b are real numbers. For example, a value range of "0-5" means that all real numbers in the range of "0-5" are listed herein, and "0-5" is just a short representation of combinations of these values. In addition, a parameter expressed as an integer greater than or equal to 2 is equivalent to disclosure that the parameter is, for example, an integer among 2, 3, 4, 5, 6, 7, 8, 9, 10, 11, 12, and so on.

Unless otherwise stated, all the embodiments and optional embodiments of this application can be combined with each other to form new technical solutions.

Unless otherwise stated, all the technical features and optional technical features of this application can be combined with each other to form new technical solutions.

Unless otherwise specified, all the steps in this application can be performed sequentially or randomly, preferably sequentially. For example, a method including steps (a) and (b) indicates that the method may include steps (a) and (b) performed sequentially or may include steps (b) and (a) performed sequentially. For example, the foregoing method may further include step (c), which indicates that step (c) may be added to the method in any ordinal position, for example, the method may include steps (a), (b), and (c), steps (a), (c), and (b), steps (c), (a), and (b), or the like.

Impurities present on the surface of the positive electrode material reduce the performance of the positive electrode material.

For example, when preparing high-nickel ternary materials, a structural stability issue exists during synthesis. Therefore, to synthesize in a stable oxide form, an excess Li/Me (alloy element) condition is typically designed to synthesize a structurally stable positive electrode active material. That is, in the process of preparing high-nickel ternary materials, lithium salt is in excess in the mixture of the ternary precursor and lithium salt. The excess lithium salt does not participate in the reaction, resulting in this portion of lithium salt reacting with moisture and CO₂ in the air to form residual lithium (LiOH and Li₂CO₃). During battery cell manufacturing, the presence of residual lithium causes several issues: residual lithium has poor ionic conductivity, and its formation on the surface of the ternary material hinders lithium-ion transport in the ternary material; additionally, Li₂CO₃ reacts with the electrolyte, generating gas and heat, and affecting the safety of the battery.

Applying a positive electrode material with residual lithium to the coating reduces the performance of the battery. For example, contact between the positive electrode material in the coating and air leads to performance degradation, and contact between the positive electrode material and the electrolyte causes interfacial side reactions.

To address the above issues, this application provides a positive electrode plate. The positive electrode plate includes a current collector and a coating disposed on at least one side of the current collector. The coating is provided with a protective film on the surface, and a material of the protective film includes a fluoride.

The current collector refers to a structure or component configured to collect current. In lithium-ion batteries, the current collector primarily refers to a metal foil, such as copper foil or aluminum foil. The current collector serves as a substrate for attaching positive or negative electrode active materials, collecting the current generated by the active material for high-current external output. Typically, aluminum foil serves as the positive electrode current collector, and copper foil serves as the negative electrode current collector.

The coating includes a positive electrode material, a binder, and a conductive agent. In the process of preparing the coating, the positive electrode material, the binder, and the conductive agent are mixed with a solvent to prepare a slurry, and the prepared slurry is applied onto the current collector to obtain the coating.

The positive electrode material is capable of providing a lithium source. When applied in a battery, during charging, lithium ions deintercalate from the crystal lattice of the positive electrode active material and, after passing through the electrolyte, intercalate into the crystal lattice of the negative electrode material; during discharging, lithium ions deintercalate from the crystal lattice of the negative electrode material and, after passing through the electrolyte, intercalate into the crystal lattice of the positive electrode material.

The binder refers to a material with adhesive properties configured to bond different substances together.

The conductive agent is added to ensure good charge-discharge performance of the electrode. During electrode plate fabrication, a certain amount of conductive material is typically added to collect microcurrents between active materials and between the active material and the current collector, reducing the contact resistance of the electrode and accelerating the movement rate of electrons. This also effectively enhances the migration rate of lithium ions in the electrode material, thereby improving the charge-discharge efficiency of the electrode.

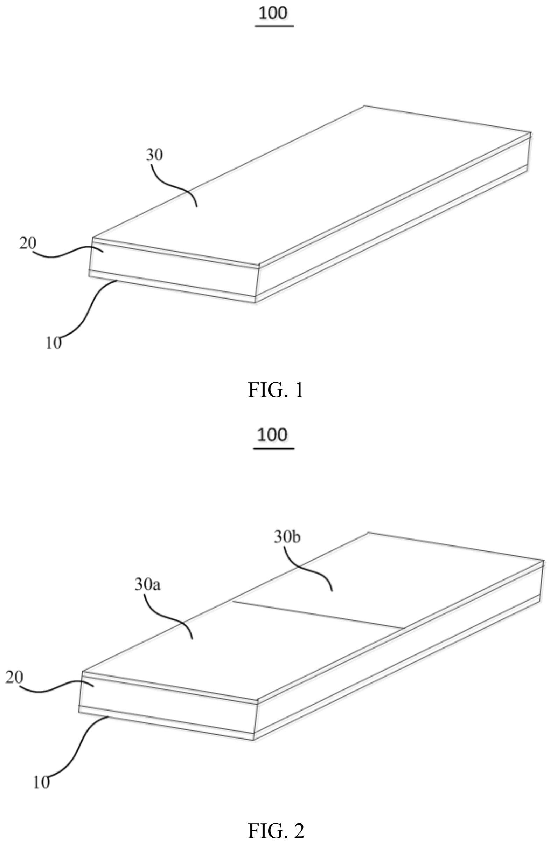

The protective film is a film structure disposed on the surface of the coating. As shown in FIG. 1, the positive electrode plate 100 includes a current collector 10, a coating 20 disposed on the current collector 10, and a protective film 30 disposed on the surface of the coating 20. It can be understood that the surface of the coating 20 refers to the exposed surface of the coating, such as the surface of the coating 20 facing away from the current collector or the side surface of the coating 20. The protective film 30 can be disposed on any surface of the coating 20, with specific placement determined based on needs. For example, in one scenario, the protective film 30 is disposed on all exposed surfaces of the coating to reduce contact between the coating and the electrolyte.

A fluoride refers to a compound containing negatively charged fluorine.

Fluorides can effectively reduce the oxidative activity on the surface of the positive electrode material, suppress oxidative decomposition of the electrolyte at the positive electrode, and promote lithium-ion transport in the solid phase. For example, the fluoride may be lithium fluoride or aluminum fluoride, with lithium fluoride being more beneficial for improving air stability.

That is, to improve the performance of the coating, a protective film is disposed on the surface of the coating, and a material of the protective film includes a fluoride. This reduces the opportunity for contact between the positive electrode material in the coating and air and mitigates the probability of interfacial reactions between the positive electrode material and the electrolyte, enhancing the stability of the positive electrode material, thereby improving the performance of the battery.

Additionally, both lithium fluoride and aluminum fluoride are ionic conductors, not obstructing lithium-ion transport or affecting wetting.

In one embodiment, a thickness range of the protective film is 1 nm to 50 nm, preferably 5 nm to 20 nm.

To allow the protective film to effectively reduce the opportunity for contact between the electrolyte and the coating while ensuring a favorable migration rate for lithium ions, the thickness range of the protective film is 1 nm to 50 nm, preferably 5 nm to 20 nm.

The range of 1 nm to 50 nm includes the minimum and maximum values of this range, as well as every value between the minimum and maximum values. Specific examples include, but are not limited to, the point values in the embodiments and 1 nm, 3 nm, 5 nm, 10 nm, 15 nm, 20 nm, 25 nm, 30 nm, 35 nm, 40 nm, 45 nm, and 50 nm.

The range of 5 nm to 20 nm includes the minimum and maximum values of this range, as well as every value between the minimum and maximum values. Specific examples include, but are not limited to, the point values in the embodiments and 5 nm, 10 nm, 15 nm, 20 nm, 25 nm, and 30 nm.

In one embodiment, the fluoride includes at least one of lithium fluoride and aluminum fluoride.

The fluoride includes at least one of lithium fluoride and aluminum fluoride. That is, the protective film may include both lithium fluoride and aluminum fluoride simultaneously, or may independently consist of lithium fluoride or aluminum fluoride. In some cases, other types of materials may be added to the protective film as needed. This application imposes no limitation, allowing design based on usage requirements.

Lithium fluoride is an inorganic compound with the chemical formula LiF, as an alkali metal halide, appearing as a white crystal at room temperature and being sparingly soluble in water.

Aluminum fluoride is an inorganic compound with the chemical formula AlF₃, insoluble in water, acids, and bases, and exhibiting very stable properties.

Lithium fluoride and aluminum fluoride are ionic conductive substances, facilitating lithium-ion transport. For example, lithium fluoride is an electronic insulator with an ionic conductivity of approximately 10⁻¹³ S cm⁻¹ to 10⁻¹⁴ S cm⁻¹.

The specific type of fluoride in this application is not limited, as long as the fluoride can be disposed on the surface of the coating, reduce the opportunity for contact between the positive electrode material in the coating and air, and mitigate the probability of interfacial reactions between the positive electrode material and the electrolyte.

In one embodiment, the protective film includes a lithium fluoride protective film and an aluminum fluoride protective film, where the lithium fluoride protective film and the aluminum fluoride protective film are stacked on the surface of the coating; and/or, the protective film includes a lithium fluoride protective film and an aluminum fluoride protective film, where at least a portion of the surface of the coating is provided with the lithium fluoride protective film, and at least another portion of the surface of the coating is provided with the aluminum fluoride protective film.

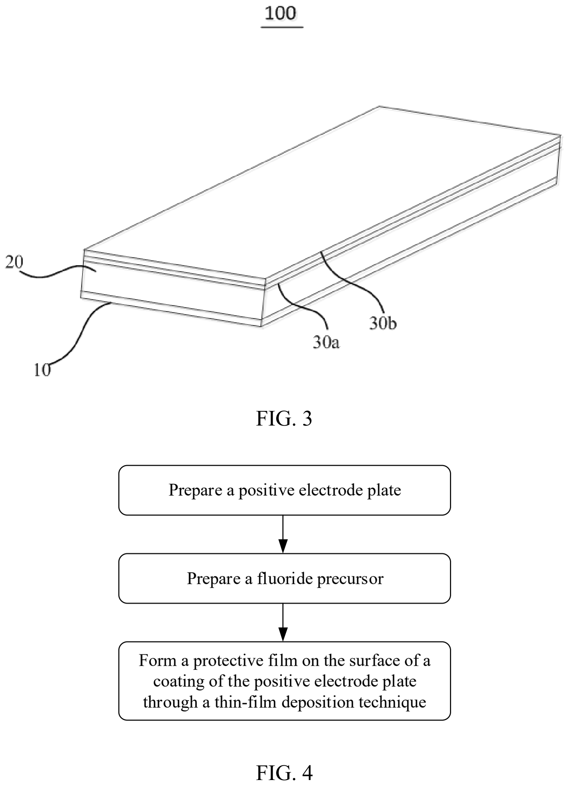

The lithium fluoride protective film and the aluminum fluoride protective film are stacked on the surface of the coating. As shown in FIG. 3, the lithium fluoride protective film 30a and the aluminum fluoride protective film 30b are alternately disposed on the surface of the coating 20. For example, the lithium fluoride protective film 30a is disposed on the surface of the coating 20, and the aluminum fluoride protective film 30b is disposed on a side of the lithium fluoride protective film 30a facing away from the coating 20. Certainly, alternatively, the aluminum fluoride protective film 30b may be disposed on the surface of the coating 20, and the lithium fluoride protective film 30a may be disposed on a side of the aluminum fluoride protective film 30b facing away from the coating 20. The number of layers of the lithium fluoride protective film 30a and the aluminum fluoride protective film 30b is not specifically limited. For instance, the lithium fluoride protective film 30a may consist of two layers, and the aluminum fluoride protective film 30b may consist of one layer, with the aluminum fluoride protective film 30b disposed between the two layers of the lithium fluoride protective film 30a. The arrangement can be set according to needs.

At least a portion of the surface of the coating is provided with the lithium fluoride protective film, and at least another portion of the surface of the coating is provided with the aluminum fluoride protective film. As shown in FIG. 2, at least a portion of the surface of the coating 20 is provided with the lithium fluoride protective film 30a, and at least another portion of the surface of the coating 20 is provided with the aluminum fluoride protective film 30b. It can be understood that the lithium fluoride protective film 30a and the aluminum fluoride protective film 30b may be arranged side by side on one surface of the coating 20. No specific limitation is imposed, and consideration can be made based on needs.

The protective film includes a lithium fluoride protective film and an aluminum fluoride protective film, meaning the protective film includes both lithium fluoride and aluminum fluoride protective films simultaneously. The thickness ratio of the lithium fluoride and aluminum fluoride protective films is not limited and can be set according to needs. For example, the film thickness of lithium fluoride and aluminum fluoride may be 1:1. Both lithium fluoride and aluminum fluoride can effectively reduce the oxidative activity on the surface of the positive electrode material, suppress oxidative decomposition of the electrolyte at the positive electrode, and promote lithium-ion transport in the solid phase. Among them, lithium fluoride is more beneficial for improving air stability. When the coating is sensitive to air, the thickness of lithium fluoride can be increased.

In one embodiment, the coating includes a positive electrode material, a coating layer is formed on the surface of the positive electrode material, and the coating layer includes at least one of a sulfur-containing compound, a boron-containing compound, and a fluoride.

The sulfur-containing compound can react with residual lithium, such as K₂S₂O₃ or Na₂S₂O₃.

The boron-containing compound can react with residual lithium, such as B₂O₃.

The positive electrode material, such as a ternary positive electrode material, particularly one with a higher nickel content, has a higher amount of residual lithium compounds on the surface during synthesis. Such surface residual lithium readily absorbs carbon dioxide and water from the air, forming layers of Li₂CO₃ and LiOH on the particle surface, which subsequently causes the following effects: Li in the material is consumed and lacks electrochemical activity, leading to capacity fade; LiOH reacts with polyvinylidene fluoride (PVDF), causing gelation of the slurry; the LiOH remaining on the electrode plate may further react with the electrolyte LiPF₆, consuming Li ions in the electrolyte and producing HF, which further corrodes the positive electrode material body, causing surface degradation; a dense Li₂CO₃ layer on the surface of the positive electrode particles also hinders Li diffusion subsequently, affecting the electrical performance of the battery.

To address the above issues, residual lithium compounds are reduced or eliminated through chemical reactions, forming a coating layer with ionic conductivity on the surface of the positive electrode material to reduce battery polarization. The coating layer includes at least one of a sulfur-containing compound, a boron-containing compound, and a fluoride.

It can be understood that substances such as sulfur-containing compounds, boron-containing compounds, and ammonium fluoride can react with residual lithium compounds in the positive electrode material. For example, the sulfur-containing compound is used to react with residual lithium (LiOH and Li₂CO₃) to reduce the residual lithium amount and increase ionic conductive substances. Sulfur compounds include K₂SₓO_{y} or Na₂SₓO_{y} (where x = 1-8, y = 1-8), such as K₂S₂O₃ or Na₂S₂O₃, with reaction equations: nLiOH + nK₂SₓO_{y-} → nLi₂S + nLi₂SOₓ + nH₂O (n = integer); nLi₂CO₃ + nK₂SₓO_{y-} → nK₂CO₃ + nLi₂SₓO_{y} (n = integer); nLiOH + nNa₂SₓO_{y-} → nLi₂S + nLi₂SOₓ + nH₂O (n = integer); nLi₂CO₃ + nNa₂SₓO_{y-} → nNa₂CO₃ + nLi₂SₓO_{y} (n = integer).

The boron-containing compound is used to react with residual lithium (LiOH and Li₂CO₃) to reduce the residual lithium amount and increase ionic conductive substances. Boron compounds include H₃BO₃ or B₂O₃, with reaction equations: nLiOH + nB₂O₃₋ → nLi₃BO₃ + nH₂O (n = integer); nLi₂CO₃ + nB₂O₃₋ → nLi₃BO₃ + nCO₂ (n = integer).

Ammonium fluoride is used to react with residual lithium (LiOH and Li₂CO₃) to reduce or eliminate residual lithium and increase ionic conductive substances, with reaction equations: 2NH₄F + Li₂CO₃₋ → 2LiF↓ + (NH₄)₂CO₃; NH₄F + LiOH₋ → LiF↓ + NH₃↑ + H₂O↑.

Considering that although ternary materials undergo modification coating during material production, basic residual lithium characterization at the material level still shows a certain amount of residual lithium, this residual lithium remains exposed to air during subsequent battery preparation processes, and such reactions persist, continuously affecting performance. This application introduces two protective processes during the preparation of the positive electrode plate to achieve comprehensive protection of the positive electrode plate.

The first process forms a coating layer on the surface of the positive electrode material, and the second process constructs a protective film on the surface of the positive electrode plate using an atomic layer deposition process.

It can be understood that the coating layer depends on the distribution of residual lithium on the surface of the original ternary material. If no residual lithium is present in a certain area, the protective film cannot be formed through chemical reaction in that area. Therefore, a dual-protection process is employed. The second protective film can effectively protect the positive electrode material not covered by the coating layer, effectively suppressing performance degradation due to contact between the surface of the positive electrode plate and air during subsequent processes, and reducing the probability of interfacial side reactions between the positive electrode and the electrolyte. The composite protective layer formed by the two processes further protects the structural stability of the positive electrode material during deep lithium intercalation and deintercalation.

It can be understood that the second process uses an atomic layer deposition process to construct a nanoscale protective film on the surface of the positive electrode plate, achieving a dense and uniform film layer without occupying excessive thickness that affects energy density, as seen in traditional gravure coating methods.

In one embodiment, the coating layer is lithium fluoride.

The coating layer being lithium fluoride is obtained through a reaction with ammonium fluoride. Residual lithium can be thoroughly removed by controlling the input amount of ammonium fluoride in the reaction. Additionally, controlling the operational steps can effectively remove reaction byproducts, thus avoiding the introduction of new impurities.

Moreover, the step of adding ammonium fluoride can be incorporated during the preparation process of the coating slurry, requiring no additional steps and enhancing the preparation efficiency of the positive electrode plate.

In one embodiment, a mass percentage of the lithium fluoride relative to a total mass of the positive electrode material is 0.01% to 5%, preferably 0.5% to 1.2%.

The total mass of the positive electrode material is the sum of the mass of the positive electrode material and the mass of lithium fluoride. For example, if the mass of lithium fluoride is m1 and the mass of the positive electrode material is m2, the mass percentage of lithium fluoride relative to the total mass of the positive electrode material is calculated as m1/(m1 + m2) × 100%.

In the process of reacting residual lithium with ammonium fluoride to obtain a lithium fluoride coating layer, the amount of ammonium fluoride to be added can be calculated based on the amount of residual lithium in the positive electrode material to completely react the residual lithium. In the resulting positive electrode material, a mass percentage of the lithium fluoride relative to a total mass of the positive electrode material is 0.01% to 5%, preferably 0.5% to 1.2%.

The range of 0.01% to 5% includes the minimum and maximum values of this range, as well as every value between the minimum and maximum values. Specific examples include, but are not limited to, the point values in the embodiments and 0.01%, 0.05%, 0.1%, 1%, 1.5%, 2%, 2.5%, 3%, 3.5%, 4%, 4.5%, and 5%.

The range of 0.5% to 1.2% includes the minimum and maximum values of this range, as well as every value between the minimum and maximum values. Specific examples include, but are not limited to, the point values in the embodiments and 0.5%, 0.7%, 0.9%, 1%, and 1.2%.

In one embodiment, a general formula of the positive electrode material in the coating is LiₓNi_{y}M_{1-y}O₂, where 0.9 ≤ x ≤ 1.15, 0.6 ≤ y ≤ 1, and M is selected from one or more of Co, Mn, and Al; and/or, a general formula of the positive electrode material in the coating is xLi₂MnO₃·(1-x)LiMO₂, where 0.1 ≤ x ≤ 0.9, and M is selected from one or more of Co, Mn, and Al.

The positive electrode material in the coating includes LiₓNi_{y}M_{1-y}O₂ with a layered structure, where 0.9 ≤ x ≤ 1.15, 0.6 ≤ y ≤ 1, and M is selected from one or more of Co, Mn, and Al; and/or includes a lithium-rich manganese-based positive electrode material xLi₂MnO₃·(1-x)LiMO₂, where 0.1 ≤ x ≤ 0.9, and M is selected from one or more of Co, Mn, and Al.

In one embodiment, this application also provides a preparation method of a positive electrode plate, including: preparing a positive electrode plate; preparing a fluoride precursor; and forming a protective film on the surface of a coating of the positive electrode plate through a thin-film deposition technique.

Thin-film deposition techniques include chemical vapor deposition and physical vapor deposition.

Chemical vapor deposition is a chemical engineering technique primarily utilizing one or more gaseous compounds or elements containing thin-film components to undergo chemical reactions on the substrate surface to form a thin film. For example, this includes an atomic layer deposition process.

Physical vapor deposition is a technique that, under vacuum conditions, uses physical methods to vaporize the surface of a material source (solid or liquid) into gaseous atoms or molecules, or partially ionize them into ions, and deposit a thin film with specific functions on the substrate surface through a low-pressure gas (or plasma) process. For example, this includes vacuum evaporation, sputter coating, arc plasma coating, ion coating, and molecular beam epitaxy.

To form a protective film on the surface of the coating of the positive electrode plate, the steps include: preparing a positive electrode plate; preparing a fluoride precursor; and forming a protective film on the surface of the coating of the positive electrode plate through a thin-film deposition technique.

In one embodiment, the thin-film deposition technique includes an atomic layer deposition process.

Atomic layer deposition is a method (technique) of forming a deposited film by alternately introducing gaseous precursors into a reactor in a pulsed manner, where the precursors chemically adsorb and react on the deposition substrate. When the precursors reach the surface of the deposition substrate, they chemically adsorb on the surface and undergo a surface reaction. Between precursor pulses, the atomic layer deposition reactor is purged with an inert gas.

To achieve a better effect with the prepared protective film, an atomic layer deposition process is preferred. The atomic layer deposition process offers better chemical stoichiometry, strong stress control capability, a smooth film surface, a wide process window, and a broader range of precursor choices.

For example, in one embodiment, to form a protective film on the positive electrode plate, prepare a positive electrode plate, utilize an atomic layer deposition process to form a protective film on the surface of the coating, and use the atomic layer deposition process to construct a nanoscale protective film on the surface of the coating. This achieves a dense and uniform film layer without occupying excessive thickness that affects energy density, as seen in traditional gravure coating methods.

In one embodiment, the fluoride includes lithium fluoride and/or aluminum fluoride.

Fluorides can effectively reduce the oxidative activity on the surface of the positive electrode material, suppress oxidative decomposition of the electrolyte at the positive electrode, and promote lithium-ion transport in the solid phase. By preparing a fluoride precursor and utilizing a thin-film deposition technique, a fluoride protective film is formed on the surface of the coating of the positive electrode plate. The fluoride precursor includes a precursor of lithium fluoride and/or a precursor of aluminum fluoride.

In one embodiment, in the step of forming a coating layer on the surface of the coating of the positive electrode plate through an atomic layer deposition process, the process includes: placing the positive electrode plate into a reaction chamber for atomic layer deposition, evacuating the chamber, and setting a deposition temperature to 200°C-250°C; introducing an appropriate fluoride precursor into the reaction chamber, forming a protective film on the surface of the coating, and releasing the vacuum to remove unreacted precursor; and repeating the above steps to obtain a protective film of preset thickness.

The material of the protective film includes a fluoride. The type of fluoride is not specifically limited, and a precursor can be selected based on the chosen fluoride type. In the step of forming a coating layer on the surface of the coating of the positive electrode plate through an atomic layer deposition process, the process includes: placing the positive electrode plate into a reaction chamber for atomic layer deposition, evacuating the chamber, and setting a deposition temperature to 200°C-250°C; introducing an appropriate fluoride precursor into the reaction chamber, forming a protective film on the surface of the coating, and releasing the vacuum to remove unreacted precursor; and repeating the above steps to obtain a protective film of preset thickness.

During the preparation of the protective film, a vacuum environment must be maintained to prevent active substances in the air from participating in reactions during film formation so as not to affect the quality of the film layer. Therefore, the positive electrode plate is placed into the reaction chamber and evacuated to prepare the protective film in a vacuum environment.

The range of 200°C-250°C includes the minimum and maximum values of this range, as well as every value between the minimum and maximum values. Specific examples include, but are not limited to, the point values in the embodiments and 200°C, 210°C, 220°C, 230°C, 240°C, and 250°C.

In one embodiment, in the step of introducing an appropriate fluoride precursor into the reaction chamber, forming a protective film on the surface of the coating, releasing the vacuum to remove unreacted precursor, and repeating the above steps to obtain a protective film of preset thickness, the process includes: introducing a precursor of aluminum fluoride into the reaction chamber, forming a protective film on the surface of the coating, and releasing the vacuum to remove unreacted precursor; introducing a precursor of lithium fluoride into the reaction chamber, forming a protective film on the surface of the coating, and releasing the vacuum to remove unreacted precursor; and repeating the above steps to obtain the protective film of preset thickness.

The fluoride includes at least one of lithium fluoride and aluminum fluoride. To obtain a protective film of lithium fluoride and aluminum fluoride, in the step of introducing an appropriate fluoride precursor into the reaction chamber, forming a protective film on the surface of the coating, releasing the vacuum to remove unreacted precursor, and repeating the above steps to obtain a protective film of preset thickness, the process includes: introducing a precursor of aluminum fluoride into the reaction chamber, forming a protective film on the surface of the coating, and releasing the vacuum to remove unreacted precursor; introducing a precursor of lithium fluoride into the reaction chamber, forming a protective film on the surface of the coating, and releasing the vacuum to remove unreacted precursor; and repeating the above steps to obtain the protective film of preset thickness.

In one embodiment, in the step of introducing a precursor of aluminum fluoride into the reaction chamber, forming a protective film on the surface of the coating, and releasing the vacuum to remove unreacted precursors, the process includes: evacuating the reaction chamber and reducing the pressure to 10 Pa or below; introducing AlCl₃ gas into the reaction chamber and maintaining for 10s-20s; introducing purge gas into the reaction chamber, releasing the vacuum to remove unreacted AlCl₃ gas; reducing the pressure in the reaction chamber to 10 Pa or below, introducing TiF₄ gas into the reaction chamber, and maintaining for 10s-20s; introducing purge gas into the reaction chamber, releasing the vacuum to remove unreacted TiF₄ gas; and repeating the above steps to obtain an aluminum fluoride protective film of preset thickness.

The precursor of aluminum fluoride includes AlCl₃ and TiF₄. In the step of preparing an aluminum fluoride protective film, the process includes: evacuating the reaction chamber and reducing the pressure to 10 Pa or below; introducing AlCl₃ gas into the reaction chamber and maintaining for 10s-20s; introducing purge gas into the reaction chamber, releasing the vacuum to remove unreacted AlCl₃ gas; reducing the pressure in the reaction chamber to 10 Pa or below, introducing TiF₄ gas into the reaction chamber, and maintaining for 10s-20s; introducing purge gas into the reaction chamber, releasing the vacuum to remove unreacted TiF₄ gas; and repeating the above steps to obtain an aluminum fluoride protective film of preset thickness.

It can be understood that AlCl₃ and TiF₄ are solid at room temperature. To obtain gaseous precursors, a temperature capable of vaporizing the precursors is set to gasify the solids, yielding gaseous precursors.

It can be understood that the step of introducing AlCl₃ gas into the reaction chamber and maintaining for 10s-20s is to introduce an appropriate amount of AlCl₃ gas into the reaction chamber. The duration of gas introduction can be selected based on actual needs, and this application imposes no specific limitation.

Purge gas is introduced into the reaction chamber to remove unreacted gases or impurities. The purge gas is an inert gas, such as argon.

In one embodiment, in the step of introducing a precursor of lithium fluoride into the reaction chamber, forming a protective film on the surface of the coating, and releasing the vacuum to remove unreacted precursors, the process includes: evacuating the reaction chamber and reducing the pressure to 10 Pa or below; introducing alkyl lithium vapor into the reaction chamber and maintaining for 10s-20s; introducing purge gas into the reaction chamber, releasing the vacuum to remove unreacted alkyl lithium vapor; reducing the pressure in the reaction chamber to 10 Pa or below, introducing TiF₄ vapor into the reaction chamber, and maintaining for 10s-20s; introducing purge gas into the reaction chamber, releasing the vacuum to remove unreacted TiF₄ vapor; and repeating the above steps to obtain a lithium fluoride protective film of preset thickness.

The precursor of lithium fluoride includes alkyl lithium and TiF₄. In the step of preparing a lithium fluoride protective film, the process includes: evacuating the reaction chamber and reducing the pressure to 10 Pa or below; introducing alkyl lithium vapor into the reaction chamber and maintaining for 10s-20s; introducing purge gas into the reaction chamber, releasing the vacuum to remove unreacted alkyl lithium vapor; reducing the pressure in the reaction chamber to 10 Pa or below, introducing TiF₄ vapor into the reaction chamber, and maintaining for 10s-20s; introducing purge gas into the reaction chamber, releasing the vacuum to remove unreacted TiF₄ vapor; and repeating the above steps to obtain a lithium fluoride protective film of preset thickness.

Alkyl lithium may be tert-butyl lithium, butyl lithium, phenyl lithium, or the like. For example, tert-butyl lithium and TiF₄ are solid at room temperature. To obtain gaseous precursors, a temperature capable of vaporizing the precursors is set to gasify the solids, yielding gaseous precursors.

In one embodiment, in the step of preparing a positive electrode plate, the process includes: mixing and reacting the positive electrode material with a reactive substance to form a coating layer on the surface of the positive electrode material; mixing the positive electrode material with the coating layer, a binder, and a conductive agent, adding a solvent, and stirring to obtain a positive electrode slurry; and applying the positive electrode slurry onto a current collector and performing drying to obtain the positive electrode plate; where the reactive substance includes at least one of a sulfur compound and a boron compound.

For example, a sulfur compound or a boron compound is mixed with the positive electrode material and reacted under certain conditions to form a coating layer on the surface of the positive electrode material; the positive electrode material with the coating layer, a binder, and a conductive agent are mixed, a solvent is added and stirred to obtain a positive electrode slurry; and the positive electrode slurry is applied onto a current collector and dried to obtain the positive electrode plate.

In one embodiment, in the step of preparing a positive electrode plate, the process includes: mixing the positive electrode material, a binder, a conductive agent, and ammonium fluoride, adding a solvent, and stirring to obtain a positive electrode slurry; and applying the positive electrode slurry onto a current collector and performing drying to obtain the positive electrode plate.

Ammonium fluoride is introduced during the slurry preparation process to react with residual lithium on the surface of the positive electrode material, forming a lithium fluoride coating layer. This can reduce the residual alkali content on the surface of the positive electrode material as needed, thereby reducing battery polarization. Compared to mixing and reacting a sulfur compound or a boron compound with the positive electrode material under certain conditions to form a coating layer on the surface of the positive electrode material, using ammonium fluoride requires no additional steps; and ammonium fluoride is directly added during the slurry preparation process, reducing process steps and improving the production efficiency of the positive electrode plate.

By converting residual lithium as a reactant into an effective lithium fluoride protective layer, the gelation of the slurry is effectively improved, achieving the removal of residual lithium and establishing a fast ionic conductor coating layer. This enhances the conductivity of the positive electrode plate, reduces polarization in lithium-ion batteries, and improves the power performance of lithium-ion batteries.

In one embodiment, an addition amount of the ammonium fluoride relative to a mass of the positive electrode material ranges from 0.009% to 4.5%, preferably 0.45% to 1.1%.

For example, if the added mass of ammonium fluoride is M1 and the mass of the positive electrode material is M2, the addition amount of ammonium fluoride relative to the mass of the positive electrode material is calculated as M1/M2 × 100%.

The amount of residual lithium in the positive electrode material can be measured by hydrochloric acid titration, and the required mass of ammonium fluoride to be added is calculated based on the measured amount of residual lithium. An addition amount of the ammonium fluoride relative to a mass of the positive electrode material ranges from 0.009% to 4.5%, preferably 0.45% to 1.1%.

The range of 0.009% to 4.5% includes the minimum and maximum values of this range, as well as every value between the minimum and maximum values. Specific examples include, but are not limited to, the point values in the embodiments and 0.009%, 0.01%, 0.1%, 0.15%, 0.2%, 0.25%, 0.3%, 0.35%, 0.4%, 0.8%, 1%, 1.5%, 2%, 2.5%, 3%, 3.5%, and 4.5%.

The range of 0.45% to 1.1% includes the minimum and maximum values of this range, as well as every value between the minimum and maximum values. Specific examples include, but are not limited to, the point values in the embodiments and 0.45%, 0.5%, 0.55%, 0.6%, 0.65%, 0.7%, 0.75%, 0.8%, 0.85%, 0.9%, 0.95%, 1.0%, and 1.1%.

In one embodiment, in the step of mixing the positive electrode material, a binder, a conductive agent, and ammonium fluoride, adding a solvent, and stirring to obtain a positive electrode slurry, the process includes: mixing the positive electrode material, the binder, the conductive agent, and ammonium fluoride for 5 min-60 min, adding the solvent, stirring at a rotation speed of 300 r/min-2000 r/min for 30 min to 3 h, and performing degassing and evacuating to obtain a positive electrode slurry with a solid content of 60%-85%.

To thoroughly mix ammonium fluoride with the positive electrode material during the slurry preparation process for effective reaction, the operation involves: mixing the positive electrode material, the binder, the conductive agent, and ammonium fluoride for 5 min-60 min, adding the solvent, stirring at a rotation speed of 300 r/min-2000 r/min for 30 min to 3 h, and performing degassing and evacuating to obtain a positive electrode slurry with a solid content of 60%-85%.

The reaction of ammonium fluoride with residual lithium involves the following chemical equations: 2NH₄F + LiCO₃ → 2LiF↓ + (NH₄)₂CO₃; NH₄F + LiOH → LiF↓ + NH₃↑ + H₂O↑.

The byproducts of the reaction are volatile or decompose into volatile substances. To facilitate the removal of byproducts, degassing and evacuating are performed during the operation.

That is, an equivalent amount of ammonium fluoride is calculated and used based on the residual lithium as the source. Under slurry stirring conditions, ammonium fluoride is thoroughly contacted, mixed uniformly, and reacted with the positive electrode material. After stirring, during the degassing stage, some gaseous byproducts are removed by evacuation.

In one embodiment, in the step of applying the positive electrode slurry onto a current collector and performing drying to obtain the positive electrode plate, the process includes: applying the positive electrode slurry onto the current collector and performing drying at a temperature of 100°C-170°C to obtain the positive electrode plate.

To effectively ensure the decomposition and removal of the reaction byproduct (NH₄)₂CO₃, the drying process adjusts the drying temperature to decompose and remove ammonium carbonate. The drying temperature is 100°C-170°C. Under these drying conditions, the byproduct (NH₄)₂CO₃ decomposes and is discharged with the airflow, facilitating rapid decomposition and removal of (NH₄)₂CO₃ and improving production efficiency.

In one embodiment, proportions of residual lithium mass in the positive electrode material relative to the mass of the positive electrode material satisfy Li₂CO₃ ≥ 0.02% and LiOH ≥ 0.2%.

To prepare a coating layer with an appropriate coating mass that yields significant beneficial effects, proportions of residual lithium mass in the positive electrode material relative to the mass of the positive electrode material satisfy Li₂CO₃ ≥ 0.02% and LiOH ≥ 0.2%.

Comprehensive protective films are achieved on the surface of the positive electrode material, the surface of the positive electrode plate, and in the depth direction. The technical effects of the protective film are as follows:

This application converts residual lithium as a reactant into an effective coating layer, effectively improving slurry gelation, achieving the removal of residual lithium, and establishing a fast ionic conductor coating layer. This enhances the conductivity of the positive electrode plate, reduces polarization in lithium-ion batteries, and improves the power performance of lithium-ion batteries. Additionally, on the basis of the coating layer, protective films of lithium fluoride and/or aluminum are added to protect the positive electrode from interfacial side reactions with the electrolyte. The composite protective layer formed by the two processes further protects the structural stability and surface stability of the positive electrode material during deep lithium intercalation and deintercalation, contributing to a prolonged lifespan of the battery.

In one embodiment, this application also provides an electrode assembly. The electrode assembly includes the positive electrode plate as described above or includes a positive electrode plate prepared by the preparation method of the positive electrode plate as described above.

Since the positive electrode plate has adopted all the technical solutions of all the embodiments described above, the electrode assembly has at least all the beneficial effects brought by the technical solutions of the embodiments described above. Details are not repeated herein.

In one embodiment, this application also provides a battery cell. The battery cell includes the electrode assembly as described above.

The electrode assembly has adopted all the technical solutions of all the embodiments described above, and therefore the battery cell has at least all the beneficial effects brought by the technical solutions of the embodiments described above. Details are not repeated herein.

In one embodiment, this application also provides a battery. The battery includes the battery cell as described above.

The battery cell has adopted all the technical solutions of all the embodiments described above, and therefore the battery has at least all the beneficial effects brought by the technical solutions of the embodiments described above. Details are not repeated herein.

In one embodiment, this application also provides an electric apparatus. The electric apparatus includes the battery cell as described above or the battery as described above.

The battery cell or the battery has adopted all the technical solutions of all the embodiments described above, and therefore the electric apparatus has at least all the beneficial effects brought by the technical solutions of the embodiments described above. Details are not repeated herein.

In addition, the battery (battery cell, battery module, battery pack) and electric apparatus of this application are described below with appropriate reference to the accompanying drawings.

An embodiment of this application provides a secondary battery.

Typically, the secondary battery includes a positive electrode plate, a negative electrode plate, an electrolyte, and a separator. During charging and discharging of the battery, active ions intercalate and deintercalate back and forth between the positive electrode plate and the negative electrode plate. The electrolyte conducts ions between the positive electrode plate and the negative electrode plate. The separator is disposed between the positive electrode plate and the negative electrode plate to primarily prevent a short circuit between the positive and negative electrodes and allow ions to pass through. The separator is the separator provided in this application.

The positive electrode plate includes a positive electrode current collector and a positive electrode film layer disposed on at least one surface of the positive electrode current collector.

For example, the positive electrode current collector includes two opposite surfaces in the thickness direction, and the positive electrode film layer is disposed on either or both of the two opposite surfaces of the positive electrode current collector.

In some embodiments, the positive electrode current collector may be a metal foil current collector or a composite current collector. For example, an aluminum foil may be used as the metal foil. The composite current collector may include a polymer material substrate and a metal layer formed on at least one surface of the polymer material substrate. The composite current collector may be formed by forming a metal material (aluminum, aluminum alloy, nickel, nickel alloy, titanium, titanium alloy, silver, silver alloy, or the like) on the polymer material substrate (for example, substrates of polypropylene (PP), polyethylene terephthalate (PET), polybutylene terephthalate (PBT), polystyrene (PS), and polyethylene (PE)).

In some embodiments, under the condition that the secondary battery is a lithium-ion battery, the positive electrode active material may be a well-known positive electrode active material used for lithium-ion batteries in the art. For example, the positive electrode active material may include at least one of the following materials: olivine-structured lithium-containing phosphate, lithium transition metal oxide, and respective modified compounds thereof. However, this application is not limited to such materials, and other conventional well-known materials that can be used as positive electrode active materials for batteries may alternatively be used. One of these positive electrode active materials may be used alone, or two or more may be used in combination. Examples of the lithium transition metal oxide may include, but are not limited to, at least one of lithium cobalt oxide (for example, LiCoO₂), lithium nickel oxide (for example, LiNiO₂), lithium manganese oxide (for example, LiMnO₂ and LiMn₂O₄), lithium nickel cobalt oxide, lithium manganese cobalt oxide, lithium nickel manganese oxide, lithium nickel cobalt manganese oxide (for example, LiNi₁/₃Co₁/₃Mn₁/₃O₂ (NCM333 for short), LiNi_{0.5}Co_{0.2}Mn_{0.3}O₂ (NCM523 for short), LiNi_{0.5}Co_{0.25}Mn_{0.25}O₂ (NCM211 for short), LiNi_{0.6}Co_{0.2}Mn_{0.2}O₂ (NCM622 for short), and LiNi_{0.8}Co_{0.1}Mn_{0.1}O₂ (NCM811 for short)), lithium nickel cobalt aluminum oxide (for example, LiNi_{0.85}Co_{0.15}Al_{0.05}O₂), and modified compounds thereof. Examples of the olivine-structured lithium-containing phosphate may include, but are not limited to, at least one of lithium iron phosphate (for example, LiFePO₄ (LFP for short)), a composite material of lithium iron phosphate and carbon, lithium manganese phosphate (for example, LiMnPO₄), a composite material of lithium manganese phosphate and carbon, lithium manganese iron phosphate, and a composite material of lithium manganese iron phosphate and carbon.

Lithium intercalation, deintercalation, and consumption accompany the charging and discharging processes of the battery. The molar amount of lithium in the battery varies when discharged to different states. In the list of positive electrode materials in this application, the molar amount of Li refers to the initial state of the material, that is, the state before feeding. When the positive electrode material is applied in a battery system and undergoes charge-discharge cycles, the molar amount of Li changes.

In the list of positive electrode materials in this application, the molar amount of O is only a theoretical value. Lattice oxygen release causes changes in the molar amount of oxygen, and the actual molar amount of O may fluctuate.

In some embodiments, the positive electrode film layer further optionally includes a binder. For example, the binder may include at least one of polyvinylidene fluoride (PVDF), polytetrafluoroethylene (PTFE), vinylidene fluoride-tetrafluoroethylene-propylene terpolymer, vinylidene fluoride-hexafluoropropylene-tetrafluoroethylene terpolymer, tetrafluoroethylene-hexafluoropropylene copolymer, and fluorine-containing acrylate resin.

In some embodiments, the positive electrode film layer further optionally includes a conductive agent. For example, the conductive agent may include at least one of superconducting carbon, acetylene black, carbon black, Ketjen black, carbon dots, carbon nanotubes, graphene, and carbon nanofiber.

In some embodiments, the positive electrode plate was prepared in the following manner: the constituents used for preparing the positive electrode plate, such as the positive electrode active material, the conductive agent, the binder, and any other constituent, were dispersed in a solvent (for example, N-methylpyrrolidone) to form a positive electrode slurry; the positive electrode slurry was applied onto the positive electrode current collector, followed by processes such as drying and cold pressing to obtain the positive electrode plate.

The negative electrode plate includes a negative electrode current collector and a negative electrode film layer disposed on at least one surface of the negative electrode current collector, where the negative electrode film layer includes a negative electrode active material.

For example, the negative electrode current collector includes two opposite surfaces in the thickness direction, and the negative electrode film layer is disposed on either or both of the two opposite surfaces of the negative electrode current collector.

In some embodiments, the negative electrode current collector may be a metal foil current collector or a composite current collector. For example, the metal foil may be a copper foil. The composite current collector may include a polymer material substrate and a metal layer formed on at least one surface of the polymer material substrate. The composite current collector may be formed by forming a metal material (copper, copper alloy, nickel, nickel alloy, titanium, titanium alloy, silver, silver alloy, or the like) on the polymer material substrate (for example, substrates of polypropylene (PP), polyethylene terephthalate (PET), polybutylene terephthalate (PBT), polystyrene (PS), and polyethylene (PE)).

In some embodiments, the negative electrode active material may be a negative electrode active material for batteries well-known in the art. For example, the negative electrode active material may include at least one of the following materials: artificial graphite, natural graphite, soft carbon, hard carbon, silicon-based materials, tin-based materials, lithium titanate, or the like. The silicon-based material may be selected from at least one of elemental silicon, silicon-oxygen compounds, silicon-carbon composites, silicon-nitrogen composites, and silicon alloys. The tin-based material may be selected from at least one of elemental tin, tin-oxygen compounds, or tin alloys. However, this application is not limited to these materials, and other conventional materials that can be used as negative electrode active materials for batteries may be used instead. One of these negative electrode active materials may be used alone, or two or more may be used in combination.

In some embodiments, the negative electrode film layer further optionally includes a binder. The binder may be selected from at least one of styrene-butadiene rubber (SBR), polyacrylic acid (PAA), polyacrylic acid sodium (PAAS), polyacrylamide (PAM), polyvinyl alcohol (PVA), sodium alginate (SA), polymethacrylic acid (PMAA), and carboxymethyl chitosan (CMCS).

In some embodiments, the negative electrode film layer further optionally includes a conductive agent. The conductive agent may be selected from at least one of superconducting carbon, acetylene black, carbon black, Ketjen black, carbon dots, carbon nanotubes, graphene, and carbon nanofiber.

In some embodiments, the negative electrode film layer may further optionally include another additive, such as a thickener (for example, sodium carboxymethyl cellulose (CMC-Na)).

In some embodiments, the negative electrode plate was prepared in the following manner: the constituents used for preparing the negative electrode plate, such as the negative electrode active material, the conductive agent, the binder, and any other constituent, were dispersed in a solvent (for example, deionized water) to form a negative electrode slurry; the negative electrode slurry was applied onto the negative electrode current collector, followed by processes such as drying and cold pressing to obtain the negative electrode plate.

An electrolyte conducts ions between the positive electrode plate and the negative electrode plate. The electrolyte is not specifically limited to any particular type in this application and may be selected based on needs.

In some embodiments, the electrolyte is a liquid electrolyte. The liquid electrolyte includes an electrolytic salt and a solvent.

In some embodiments, the electrolytic salt may be selected from at least one of lithium hexafluorophosphate, lithium tetrafluoroborate, lithium perchlorate, lithium hexafluoroarsenate, lithium bis(fluorosulfonyl)imide, lithium bis(trifluoromethanesulfonyl)imide, lithium trifluoromethanesulfonate, lithium difluorophosphate, lithium difluoro(oxalato)borate, lithium bis(oxalato)borate, lithium difluoro(bisoxalato)phosphate, and lithium tetrafluoro(oxalato)phosphate.

In some embodiments, the solvent may be selected from at least one of ethylene carbonate, propylene carbonate, ethyl methyl carbonate, diethyl carbonate, dimethyl carbonate, dipropyl carbonate, methyl propyl carbonate, ethyl propyl carbonate, butylene carbonate, fluoroethylene carbonate, methyl formate, methyl acetate, ethyl acetate, propyl acetate, methyl propionate, ethyl propionate, propyl propionate, methyl butyrate, ethyl butyrate, 1,4-butyrolactone, sulfolane, methylsulfonylmethane, ethyl methyl sulfone, and diethyl sulfone.

In some embodiments, the electrolyte further optionally includes an additive. For example, the additive may include a negative electrode film-forming additive or a positive electrode film-forming additive, or may include an additive capable of improving certain performance of the battery, such as an additive for improving overcharge performance of the battery, or an additive for improving high-temperature or low-temperature performance of the battery.

In some embodiments, the secondary battery further includes a separator. The separator is not limited to any particular type in this application and may be any well-known porous separator with good chemical stability and mechanical stability.

In some embodiments, a material of the separator may be selected from at least one of glass fiber, non-woven fabric, polyethylene, polypropylene, and polyvinylidene fluoride. The separator may be a single-layer film or a multi-layer composite film, with no particular limitation. When the separator is a multi-layer composite film, all layers may be made of the same or different materials, with no particular limitation.

In some embodiments, the positive electrode plate, the negative electrode plate, and the separator were made into the electrode assembly through winding or lamination.

In some embodiments, the secondary battery may include an outer package. The outer package may be used for packaging the electrode assembly and electrolyte described above.

In some embodiments, the outer package of the secondary battery may be a hard shell, such as a hard plastic shell, an aluminum shell, or a steel shell. The outer package of the secondary battery may alternatively be a soft pack, such as a pouch. A material of the soft pack may be plastic. Examples of the plastic include polypropylene, polybutylene terephthalate, polybutylene succinate, and the like.

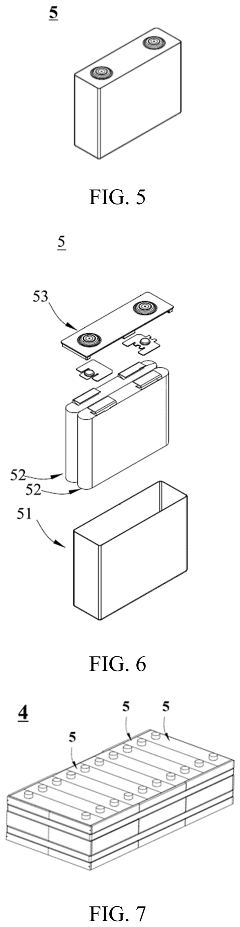

This application imposes no specific limitation on a shape of the secondary battery, and the secondary battery may be cylindrical, rectangular, or of any other shape. For example, FIG. 5 shows a rectangular battery cell 5 as an example.

In some embodiments, referring to FIG. 6, the outer package may include a housing 51 and a cover plate 53. The housing 51 may include a base plate and a side plate connected onto the base plate, and the base plate and the side plate enclose an accommodating cavity. The housing 51 has an opening communicating with the accommodating cavity, and the cover plate 53 can cover the opening to close the accommodating cavity. The positive electrode plate, the negative electrode plate, and the separator may be made into an electrode assembly 52 through winding or lamination. The electrode assembly 52 is packaged in the accommodating cavity. The liquid electrolyte infiltrates the electrode assembly 52. The number of electrode assemblies 52 contained in the battery cell 5 may be one or more, and persons skilled in the art may select the number based on specific actual needs.

In some embodiments, secondary batteries were assembled into a battery module, and the battery module may include one or more secondary batteries. The specific quantity may be chosen by persons skilled in the art based on the use and capacity of the battery module.

FIG. 7 shows a battery module 4 as an example. Referring to FIG. 7, in the battery module 4, a plurality of battery cells 5 may be sequentially arranged in a length direction of the battery module 4. Alternatively, the battery cells 5 may be arranged in any other manner. Further, the plurality of battery cells 5 may be fastened through fasteners.

Optionally, the battery module 4 may further include a shell with an accommodating space, and the plurality of battery cells 5 are accommodated in the accommodating space.

In some embodiments, the battery module may be further assembled into a battery pack, and the battery pack may include one or more battery modules. The specific quantity may be chosen by persons skilled in the art based on the use and capacity of the battery pack.

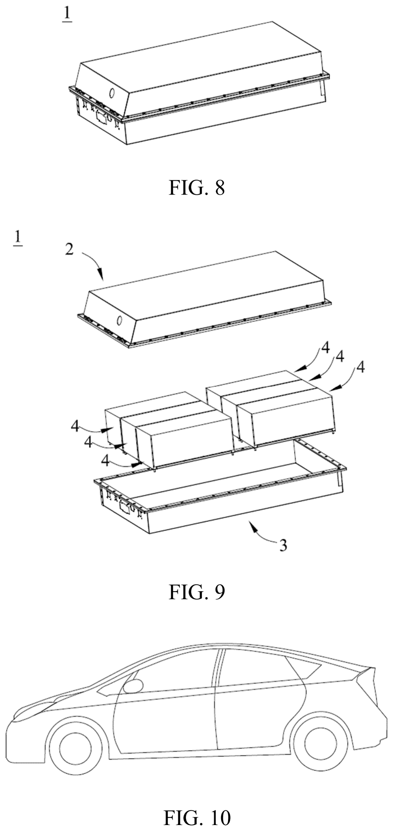

FIG. 8 and FIG. 9 show a battery pack 1 as an example. Referring to FIG. 8 and FIG. 9, the battery pack 1 may include a battery box and a plurality of battery modules 4 arranged in the battery box. The battery box includes an upper box body 2 and a lower box body 3. The upper box body 2 can cover the lower box body 3 to form an enclosed space for accommodating the battery modules 4. The plurality of battery modules 4 may be arranged in the battery box in any manner.

In addition, this application further provides an electric apparatus. The electric apparatus includes at least one of the secondary battery, battery module, or battery pack provided in this application. The secondary battery, battery module, or battery pack may be used as a power source for the electric apparatus or as an energy storage unit of the electric apparatus. The electric apparatus may include a mobile device (for example, a mobile phone or a notebook computer), an electric vehicle (for example, a battery electric vehicle, a hybrid electric vehicle, a plug-in hybrid electric vehicle, an electric bicycle, an electric scooter, an electric golf vehicle, or an electric truck), an electric train, a ship, a satellite system, an energy storage system, or the like, but is not limited thereto.

For the electric apparatus, a secondary battery, a battery module, or a battery pack may be selected according to requirements for using the electric apparatus.

FIG. 10 shows an electric apparatus as an example. This electric apparatus is a battery electric vehicle, a hybrid electric vehicle, a plug-in hybrid electric vehicle, or the like. To satisfy requirements of the electric apparatus for high power and high energy density of the secondary battery, a battery pack or a battery module may be used.

In another example, the apparatus may be a mobile phone, a tablet computer, a notebook computer, or the like. The apparatus is usually required to be light and thin, and the secondary battery may be used as a power supply.

### Examples

### Example 1

### Preparation of positive electrode slurry

Positive electrode material LiNi_{0.8}Co_{0.1}Mn_{0.1}O₂, binder PVDF, and conductive agent carbon black were weighed at a ratio of 90:5:5. Based on the amount of residual lithium, a corresponding amount of ammonium fluoride was added (the percentage of residual alkali in the positive electrode material was 0.2%, and the mass of added ammonium fluoride relative to the mass of the positive electrode material was 0.18%). After dry mixing for 15 minutes, NMP was added, and high-speed stirring at 1000 r/min was performed for 120 minutes, followed by degassing and evacuation, ultimately yielding a uniform positive electrode slurry with a solid content of 70%.

### Preparation of positive electrode plate

The positive electrode slurry described above was uniformly applied onto a positive electrode current collector aluminum foil. The oven temperature was set to 130°C to dry the electrode plate. An atomic layer deposition apparatus was then used to deposit an aluminum fluoride thin film layer on the positive electrode plate. Precursor A was ground TiF₄, precursor B was AlCl₃, and the deposition temperature was 250°C. The positive electrode plate was placed into an atomic layer deposition (ALD) reaction chamber, with deposition parameters and process as follows: (1) Evacuate the reaction chamber until the pressure dropped below 10 Pa; (2) Open the valve of precursor A, introduce AlCl₃ vapor into the reaction chamber, and maintain for 15 seconds, with the vapor generation temperature at 120°C; (3) Introduce argon gas into the reaction chamber for 120 seconds, then release the vacuum to remove unreacted precursor A; (4) When the pressure in the reaction chamber dropped to 10 Pa, open the valve of precursor B, introduce TiF₄ vapor into the reaction chamber, and maintain for 15 seconds, with the vapor generation temperature at 120°C; and (5) Introduce argon gas into the reaction chamber for 100 seconds, then release the vacuum to remove unreacted precursor B. Steps (1) to (5) constituted one complete cycle, and the cycle was repeated to obtain a protective film with a thickness of approximately 10 nm. The electrode plate with the protective film was subjected to processes such as cold pressing and slitting to obtain an assemblable positive electrode plate.

### Preparation of battery components and finished product

Negative electrode material graphite, conductive agent acetylene black, binder styrene-butadiene rubber (SBR), thickener sodium carboxymethyl cellulose (CMC), and deionized water solvent system were thoroughly stirred and mixed at a mass ratio of 90:5:2:2:1 until uniform. The mixture was applied onto a negative electrode current collector copper foil, dried, and subjected to processes such as cold pressing and slitting to obtain a negative electrode plate. A PE porous polymer film coated with alumina ceramic was used as the separator. The electrolyte was a 1 mol/L LiPF₆ solution, with an organic solvent mixture of ethylene carbonate (EC), diethyl carbonate (DEC), and dimethyl carbonate (DMC) at a volume ratio of 5:2:3, appropriately supplemented with film-forming additives to prepare the desired electrolyte. The positive electrode plate, separator, and negative electrode plate were assembled in a dry room environment with humidity less than 2%, baked and dried, injected with the corresponding electrolyte, and encapsulated. After formation testing, a soft-pack battery with a capacity of 2.8 Ah was prepared and subjected to electrical performance testing.

### Example 2

### Preparation of positive electrode slurry

Positive electrode material LiNi_{0.8}Co_{0.1}Mn_{0.1}O₂, binder PVDF, and conductive agent carbon black were weighed at a ratio of 90:5:5. Based on the amount of residual lithium, a corresponding amount of ammonium fluoride was added. After dry mixing for 15 minutes, NMP was added, and high-speed stirring at 1000 r/min was performed for 120 minutes, followed by degassing and evacuation, ultimately yielding a uniform positive electrode slurry with a solid content of 70%.

### Preparation of positive electrode plate

The positive electrode slurry described above was uniformly applied onto a positive electrode current collector aluminum foil. The oven temperature was set to 130°C to dry the electrode plate. An atomic layer deposition apparatus was then used to deposit an aluminum fluoride protective film and a lithium fluoride protective film on the positive electrode plate. For the aluminum fluoride film, precursor A was ground TiF₄, and precursor B was AlCl₃; for the lithium fluoride film, precursor A was tert-butyl lithium, and precursor B was TiF₄. The deposition temperature was 250°C. The positive electrode plate was placed into an atomic layer deposition (ALD) reaction chamber. The deposition parameters and process for the aluminum fluoride composite film were as follows: (1) Evacuate the reaction chamber until the pressure dropped below 10 Pa; (2) Open the valve of precursor A, introduce AlCl₃ vapor into the reaction chamber, and maintain for 15 seconds, with the vapor generation temperature at 120°C; (3) Introduce argon gas into the reaction chamber for 120 seconds, then release the vacuum to remove unreacted precursor A; (4) When the pressure in the reaction chamber dropped to 10 Pa, open the valve of precursor B, introduce TiF₄ vapor into the reaction chamber, and maintain for 15 seconds, with the vapor generation temperature at 120°C; and (5) Introduce argon gas into the reaction chamber for 120 seconds, then release the vacuum to remove unreacted precursor B. Steps (1) to (5) constituted one complete aluminum fluoride deposition cycle. The deposition parameters and process for the lithium fluoride composite film were as follows: (1) Evacuate the reaction chamber until the pressure dropped below 10 Pa; (2) Open the valve of precursor A, introduce tert-butyl lithium vapor into the reaction chamber, and maintain for 15 seconds, with the vapor generation temperature at 165°C; (3) Introduce argon gas into the reaction chamber for 120 seconds, then release the vacuum to remove unreacted precursor A; (4) When the pressure in the reaction chamber dropped to 10 Pa, open the valve of precursor B, introduce TiF₄ vapor into the reaction chamber, and maintain for 15 seconds, with the vapor generation temperature at 120°C; and (5) Introduce argon gas into the reaction chamber for 120 seconds, then release the vacuum to remove unreacted precursor B. Steps (1) to (5) constituted one complete lithium fluoride deposition cycle. Cycles of LiF and AlF₃ were alternately performed at a 1:1 ratio to obtain a protective film with a thickness of approximately 10 nm. The electrode plate with the protective film was subjected to processes such as cold pressing and slitting to obtain an assemblable positive electrode plate.

The preparation of battery components and the finished product was the same as in Example 1.

### Example 3

Based on Example 2, the number of deposition cycles was adjusted to obtain a protective film with a thickness of 20 nm.

### Example 4

### Preparation of positive electrode slurry

Positive electrode material LiNi_{0.8}Co_{0.1}Mn_{0.1}O₂, binder PVDF, and conductive agent carbon black were weighed at a ratio of 90:5:5. After dry mixing for 15 minutes, NMP was added, and high-speed stirring at 1000 r/min was performed for 120 minutes, followed by degassing, ultimately yielding a uniform positive electrode slurry with a solid content of 70%.

The preparation of the positive electrode plate was the same as in Example 2.

The preparation of battery components and the finished product was the same as in Example 1.

### Examples 5 to 9

Based on Example 1, the number of deposition cycles was adjusted to obtain protective films of different thicknesses.

### Comparative Example 1

### Preparation of positive electrode slurry

Positive electrode material LiNi_{0.8}Co_{0.1}Mn_{0.1}O₂, binder PVDF, and conductive agent carbon black were weighed at a ratio of 90:5:5. After dry mixing for 15 minutes, NMP was added, and high-speed stirring at 1000 r/min was performed for 120 minutes, followed by degassing, ultimately yielding a uniform positive electrode slurry with a solid content of 70%.

### Preparation of positive electrode plate

The positive electrode slurry was uniformly applied onto a positive electrode current collector aluminum foil and dried.

The preparation of battery components and the finished product was the same as in Example 1.

### Comparative Example 2

### Preparation of positive electrode slurry

The preparation method of the positive electrode slurry was the same as that for the positive electrode slurry in Example 1.

### Preparation of positive electrode plate

The positive electrode slurry was uniformly applied onto a positive electrode current collector aluminum foil and dried.

The preparation of battery components and the finished product was the same as in Example 1.

Testing methods for the prepared batteries were as follows:

### 1. Slurry standing test

The prepared positive electrode slurry was allowed to stand for 24 hours in an environment with a temperature of 25°C and humidity of 40%, and the surface condition of the positive electrode slurry was observed.

### 2. Gas production test

A fully charged lithium-ion battery was placed in a 70°C constant temperature chamber. After 30 days, the volume was measured by the displacement method and converted to mL/Ah.

### 3. Cycling test

Charge-discharge testing was conducted 300 times at 1C/1C within a voltage range of 2.8-4.25 V under a temperature of 45°C, and the capacity retention rate was recorded.

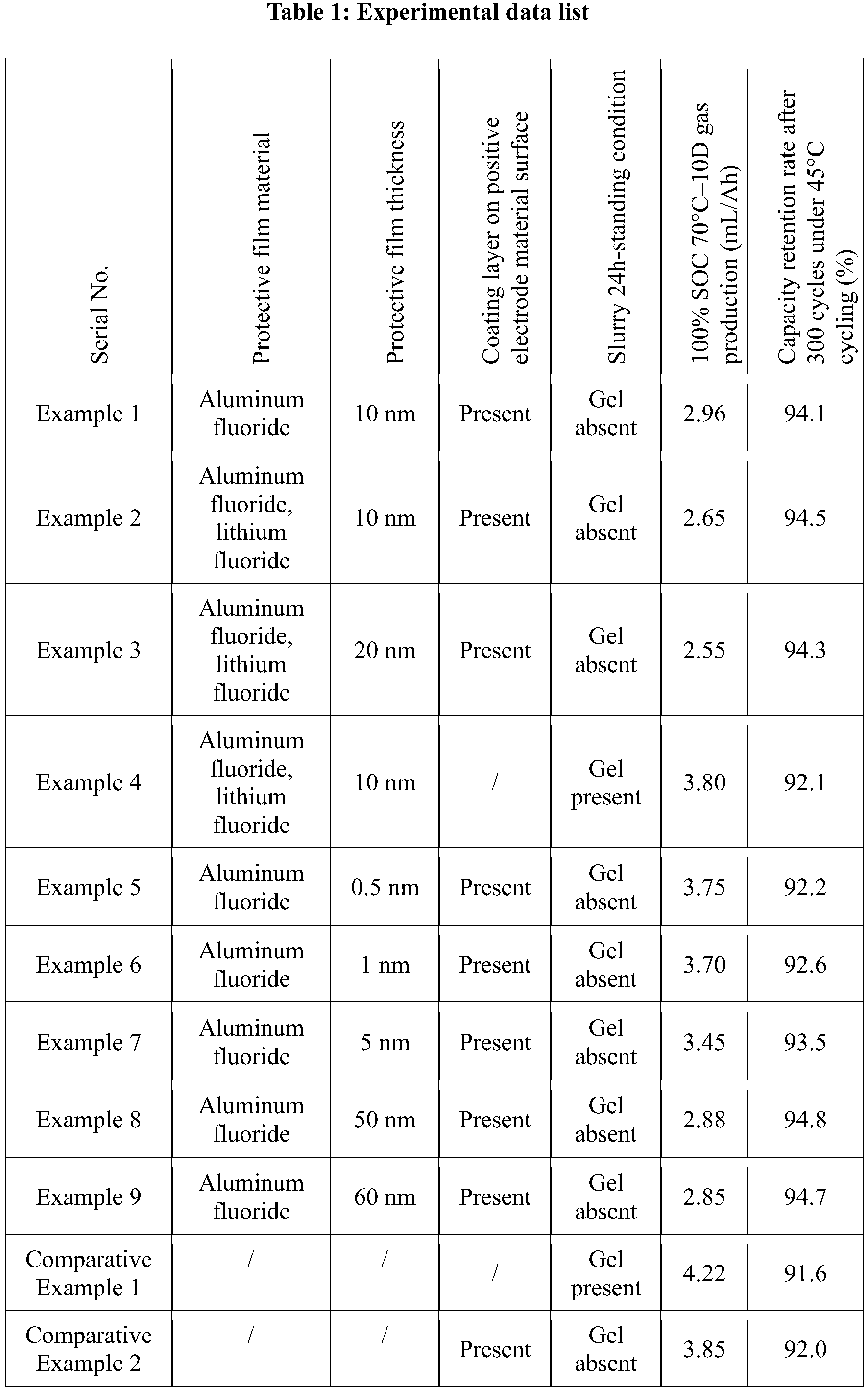

From the table above, the following can be observed: This application effectively improves slurry gelation by adding an additive to remove residual lithium during the stirring of the positive electrode material. The protective film effectively enhances the specific capacity of the battery, reduces high-temperature gas production levels, and improves the high-temperature cycle life of the battery. This is because the composite protective film, while purifying residual lithium, produces byproducts and a composite protective film that both possess ionic transport properties, thereby improving the ionic transport performance on the surface of the positive electrode material. Additionally, the protective film effectively protects the surface of the positive electrode material under high-temperature degradation conditions, suppressing oxidation and side reactions of the active material with the electrolyte, maintaining the structural stability and surface stability of the positive electrode material, and significantly enhancing the cycle life and gas production levels of the battery.

The foregoing descriptions are merely preferred embodiments of this application, but are not intended to limit the patent scope of this application. All equivalent structural transformations made by using the content of the specification and drawings of this application or directly/indirectly used in other related technical fields under the application conception of this application are included in the patent protection scope of this application.

## Claims

1. A positive electrode plate, wherein the positive electrode plate comprises a current collector and a coating disposed on at least one side of the current collector, wherein the coating is provided with a protective film on the surface, and a material of the protective film comprises a fluoride.

2. The positive electrode plate according to claim 1, wherein a thickness range of the protective film is 1 nm to 50 nm, preferably 5 nm to 20 nm.

3. The positive electrode plate according to claim 1 or 2, wherein the fluoride comprises at least one of lithium fluoride and aluminum fluoride.

4. The positive electrode plate according to any one of claims 1 to 3, wherein the protective film comprises a lithium fluoride protective film and an aluminum fluoride protective film, wherein the lithium fluoride protective film and the aluminum fluoride protective film are stacked on the surface of the coating;
and/or, the protective film comprises a lithium fluoride protective film and an aluminum fluoride protective film, wherein at least a portion of the surface of the coating is provided with the lithium fluoride protective film, and at least another portion of the surface of the coating is provided with the aluminum fluoride protective film.

5. The positive electrode plate according to any one of claims 1 to 4, wherein the coating comprises a positive electrode material, a coating layer is formed on the surface of the positive electrode material, and the coating layer comprises at least one of a sulfur-containing compound, a boron-containing compound, and a fluoride.

6. The positive electrode plate according to claim 5, wherein the coating layer is lithium fluoride.

7. The positive electrode plate according to claim 6, wherein a mass percentage of the lithium fluoride relative to a total mass of the positive electrode material is 0.01% to 5%, preferably 0.5% to 1.2%.

8. The positive electrode plate according to any one of claims 1 to 7, wherein a general formula of the positive electrode material in the coating is LiₓNi_{y}M_{1-y}O₂, wherein 0.9 ≤ x ≤ 1.15, 0.6 ≤ y ≤ 1, and M is selected from one or more of Co, Mn, and Al;
and/or, the general formula of the positive electrode material in the coating is ₓLi₂MnO₃·(1-x)LiMO₂, wherein 0.1 ≤ x ≤ 0.9, and M is selected from one or more of Co, Mn, and Al.

9. A preparation method of the positive electrode plate according to any one of claims 1 to 8, comprising:
preparing a positive electrode plate;
preparing a fluoride precursor; and
forming a protective film on the surface of the coating of the positive electrode plate through a thin-film deposition technique.

10. The preparation method of the positive electrode plate according to claim 9, wherein the thin-film deposition technique comprises an atomic layer deposition process.

11. The preparation method of the positive electrode plate according to claim 9 or 10, wherein the fluoride comprises lithium fluoride and/or aluminum fluoride.

12. The preparation method of the positive electrode plate according to claim 10 or 11, wherein the step of forming a coating layer on the surface of the coating of the positive electrode plate through an atomic layer deposition process comprises:
placing the positive electrode plate into a reaction chamber for atomic layer deposition, evacuating the chamber, and setting a deposition temperature to 200°C-250°C;
introducing an appropriate fluoride precursor into the reaction chamber, forming a protective film on the surface of the coating, releasing the vacuum to remove unreacted precursor, and repeating the above steps to obtain a protective film of preset thickness.

13. The preparation method of the positive electrode plate according to claim 12, wherein in the step of introducing an appropriate fluoride precursor into the reaction chamber, forming a protective film on the surface of the coating, releasing the vacuum to remove unreacted precursor, and repeating the above steps to obtain a protective film of preset thickness, the process comprises:
introducing a precursor of aluminum fluoride into the reaction chamber, forming a protective film on the surface of the coating, and releasing the vacuum to remove unreacted precursor;
introducing a precursor of lithium fluoride into the reaction chamber, forming a protective film on the surface of the coating, and releasing the vacuum to remove unreacted precursor; and
repeating the above steps to obtain the protective film of preset thickness.

14. The preparation method of the positive electrode plate according to claim 13, wherein in the step of introducing a precursor of aluminum fluoride into the reaction chamber, forming a protective film on the surface of the coating, and releasing the vacuum to remove unreacted precursors, the process comprises:
evacuating the reaction chamber and reducing the pressure to 10 Pa or below;
introducing AlCl₃ gas into the reaction chamber and maintaining for 10s-20s;
introducing purge gas into the reaction chamber, releasing the vacuum to remove unreacted AlCl₃ gas;
reducing the pressure in the reaction chamber to 10 Pa or below, introducing TiF₄ gas into the reaction chamber, and maintaining for 10s-20s;
introducing purge gas into the reaction chamber, releasing the vacuum to remove unreacted TiF₄ gas; and
repeating the above steps to obtain an aluminum fluoride protective film of preset thickness.

15. The preparation method of the positive electrode plate according to claim 13 or 14, wherein in the step of introducing a precursor of lithium fluoride into the reaction chamber, forming a protective film on the surface of the coating, and releasing the vacuum to remove unreacted precursors, the process comprises:
evacuating the reaction chamber and reducing the pressure to 10 Pa or below;
introducing alkyl lithium vapor into the reaction chamber and maintaining for 10s-20s;
introducing purge gas into the reaction chamber, releasing the vacuum to remove unreacted alkyl lithium vapor;
reducing the pressure in the reaction chamber to 10 Pa or below, introducing TiF₄ vapor into the reaction chamber, and maintaining for 10s-20s;
introducing purge gas into the reaction chamber, releasing the vacuum to remove unreacted TiF₄ vapor; and
repeating the above steps to obtain a lithium fluoride protective film of preset thickness.

16. The preparation method of the positive electrode plate according to any one of claims 9 to 15, wherein in the step of preparing a positive electrode plate, the process comprises:
mixing and reacting the positive electrode material with a reactive substance to form a coating layer on the surface of the positive electrode material;
mixing the positive electrode material with the coating layer, a binder, and a conductive agent, adding a solvent, and stirring to obtain a positive electrode slurry; and
applying the positive electrode slurry onto a current collector and performing drying to obtain the positive electrode plate;
wherein the reactive substance comprises at least one of a sulfur compound and a boron compound.

17. The preparation method of the positive electrode plate according to any one of claims 9 to 15, wherein in the step of preparing a positive electrode plate, the process comprises:
mixing the positive electrode material, a binder, a conductive agent, and ammonium fluoride, adding a solvent, and stirring to obtain a positive electrode slurry; and
applying the positive electrode slurry onto a current collector and performing drying to obtain the positive electrode plate.

18. The preparation method of the positive electrode plate according to claim 17, wherein an addition amount of ammonium fluoride relative to a mass of the positive electrode material ranges from 0.009% to 4.5%, preferably 0.45% to 1.1%.

19. The preparation method of the positive electrode plate according to claim 17 or 18, wherein in the step of mixing the positive electrode material, a binder, a conductive agent, and ammonium fluoride, adding a solvent, and stirring to obtain a positive electrode slurry, the process comprises:
mixing the positive electrode material, binder, conductive agent, and ammonium fluoride for 5 min-60 min, adding the solvent, stirring at a rotation speed of 300 r/min-2000 r/min for 30 min to 3 h, and performing degassing and evacuating to obtain a positive electrode slurry with a solid content of 60%-85%.

20. The preparation method of the positive electrode plate according to any one of claims 17 to 19, wherein in the step of applying the positive electrode slurry onto a current collector and performing drying to obtain the positive electrode plate, the process comprises:
applying the positive electrode slurry onto the current collector and performing drying at a temperature of 100°C-170°C to obtain the positive electrode plate.

21. The preparation method of the positive electrode plate according to any one of claims 16 to 20, wherein proportions of residual lithium mass in the positive electrode material relative to the mass of the positive electrode material satisfies Li₂CO₃ ≥ 0.02% and LiOH ≥ 0.2%.

22. An electrode assembly, wherein the electrode assembly comprises the positive electrode plate according to any one of claims 1 to 8, or comprises a positive electrode plate prepared by the preparation method of a positive electrode plate according to any one of claims 9 to 21.

23. A battery cell, wherein the battery cell comprises the electrode assembly according to claim 22.

24. A battery, wherein the battery comprises the battery cell according to claim 23.

25. An electric apparatus, wherein the electric apparatus comprises the battery cell according to claim 23 or the battery according to claim 24.
